# DEMANDE DE BREVET EUROPEEN

(11) **EP 1 760 880 A1**
(43) Date de publication de la demande: **07.03.2007**
(21) Numéro de dépôt: 06291378.5
(22) Date de dépôt: 31.08.2006
(51) Int. Cl.: H03H 3/02, H03H 9/17

(54) **Support pour résonateur acoustique et circuit intégré correspondant**

(30) Priorité: 05.09.2005 FR 0509050
(71) Demandeur: STMicroelectronics SA, 92120 Montrouge (FR)
(72) Inventeur: Bouche, Guillaume, 38000 Grenoble (FR); Parat, Guy, 38640 Claix (FR)
(74) Mandataire: Zapalowicz, Francis

(57) **Abrégé**

La présente invention concerne un circuit intégré comprenant au moins un niveau d'interconnexion (1) et un résonateur acoustique muni d'un élément actif (12) et d'un support (11) comprenant au moins un ensemble bicouche comprenant une couche de matériau à forte impédance acoustique (8) et une couche de matériau à faible impédance acoustique (10), ledit support (11) comprend en outre un élément en saillie (7) disposé sur un niveau de métallisation (4) du niveau d'interconnexion (1) permettant de réaliser un contact électrique entre un niveau d'interconnexion (1) et l'élément actif (12) du résonateur acoustique.

## Description

La présente invention concerne des circuits intégrés, et plus particulièrement des circuits intégrés comprenant un ou plusieurs résonateurs acoustiques de préférence piézoélectriques pouvant être utilisés dans des applications de traitement du signal, par exemple en servant dans une fonction de filtrage.

Il est connu dans l'état de la technique de réaliser des résonateurs acoustiques ou piézoélectriques disposés sur des niveaux d'interconnexions ou dans des niveaux d'interconnexions. De manière conventionnelle, les résonateurs acoustiques comprennent généralement un élément actif et un support qui constitue un miroir acoustique. De tels résonateurs sont ainsi solidaires du circuit intégré tout en devant être isolés acoustiquement ou mécaniquement par rapport à celui ci. À cet effet, les supports pour résonateurs acoustiques permettent de réaliser cette isolation. Ainsi pour réaliser une telle isolation, plusieurs structures d'un support pour résonateurs acoustiques ont été envisagées.

En particulier, une de ces structures consiste à réaliser un support comprenant au moins un ensemble bicouche constitué d'au moins une couche de matériau à forte impédance acoustique et d'une couche de matériau à faible impédance acoustique réalisée à l'aide d'un matériau de faible permittivité électrique tel qu'il a été décrit dans la demande de brevet WO 2004/051848. De cette façon, plus la différence d'impédance acoustique entre les matériaux des couches du support est importante, plus les ondes acoustiques qui seraient susceptibles de se propager dans le circuit intégré sont réfléchies. La propagation de ces ondes est ainsi minimisée dans le circuit intégré.

Une autre structure possible consiste à réaliser un support comprenant une alternance d'au moins deux couches isolantes de faible impédance acoustique et d'au moins deux couches de métal de forte impédance acoustique empilées les unes sur les autres sur un substrat tel que décrit dans le document US 6,542,054. Les couches de métal sont comprises dans des couches auxiliaires pour éviter de recouvrir l'ensemble de la surface des couches isolantes afin d'obtenir un support qui présente une surface plane. Aucune indication n'est donnée pour réaliser la connexion d'un tel résonateur acoustique au sein du circuit intégré.

Une autre de ces structures consiste à réaliser un certain nombre de résonateurs acoustiques reliés entre eux par l'intermédiaire de leurs électrodes et également par l'intermédiaire d'une couche conductrice afin d'améliorer la fonction de filtrage d'un circuit intégré tel qu'il est décrit dans la demande de brevet US 2004/0124952. Cette couche conductrice agit de façon à coupler électriquement l'ensemble de l'architecture. Aucune indication n'est donnée pour réaliser la connexion d'un tel résonateur acoustique au sein du circuit intégré.

Une autre structure encore possible consiste à réaliser un support pour résonateur acoustique qui est constitué par l'empilement d'une cavité remplie d'air qui peut être obtenue à la suite d'une gravure par voie chimique ou par voie plasma et d'une membrane en nitrure de silicium qui est disposée sur une telle cavité. La membrane en nitrure de silicium entoure ainsi l'ensemble de la cavité remplie d'air et se retrouve directement en contact avec l'élément actif du résonateur acoustique. La cavité remplie d'air peut être supportée par une couche d'oxyde de silicium. En d'autres termes, cette cavité est prise en sandwich entre une couche d'oxyde de silicium et la membrane en nitrure de silicium. Le résonateur acoustique est également surmonté par une couche de passivation constituée à partir d'un matériau diélectrique qui sert à régler les fréquences de résonance des résonateurs acoustiques.

En particulier, les fréquences de résonance des résonateurs acoustiques sont réglées à la même fréquence par une étape d'amincissement de cette couche de passivation pour obtenir une fonction de filtrage satisfaisante du circuit intégré. Cette étape d'amincissement consiste à abraser la surface de la couche de passivation. Cependant des problèmes de collage de la membrane vers la cavité remplie d'air peuvent survenir au cours de ce procédé rendant ainsi le résonateur non fonctionnel. De façon générale, une telle architecture rend la réalisation d'un procédé faisant intervenir toutes sortes de liquides difficile à cause des problèmes de collage de la membrane. Cette architecture rend donc difficile le réglage des fréquences de résonance des résonateurs acoustiques et ne permet pas également de réaliser une membrane solide.

En outre pour réaliser une telle architecture, il est préférable d'aplanir les parois de la cavité remplie d'air pour éviter la formation d'une fente au sein de la couche piézoélectrique.

Une telle architecture est notamment décrite dans les articles scientifiques Integration of Bulk Acoustic Wave Filters : Concept and Trends, L. Elbrecht, R. Aigner et al et Integration of High-Q BAW Resonators and Fillers Above IC, Marc-Alexandre Dubois et al.

Au vu de ce qui précède, l'invention a notamment pour objet de réaliser un résonateur acoustique connecté au reste du circuit intégré et dont l'architecture présente un minimum d'aspérités et rend possible une étape d'amincissement pour régler les fréquences de résonance du résonateur acoustique.

Selon un aspect, l'invention propose un circuit intégré comprenant au moins un niveau d'interconnexion et un résonateur acoustique muni d'un élément actif et d'un support comprenant au moins un ensemble bicouche comprenant une couche de matériau à forte impédance acoustique et une couche de matériau à faible impédance acoustique, ledit support comprenant en outre un élément en saillie disposé au-dessus d'un niveau de métallisation du niveau d'interconnexion permettant de réaliser un contact électrique entre le niveau d'interconnexion et l'élément actif du résonateur acoustique.

On obtient ainsi un résonateur acoustique dont le support comporte des interconnexions intégrées et dont l'architecture présente un minimum d'aspérités. En outre, une étape d'amincissement peut être réalisée pour ajuster la fonction de filtrage du circuit intégré. Cette étape d'amincissement peut consister à abraser une partie de la surface de l'électrode supérieure de l'élément actif du résonateur ou une couche de passivation constituée à partir d'un matériau diélectrique recouvrant le résonateur acoustique.

Avantageusement, l'élément en saillie forme un contact électrique entre le niveau de métallisation du niveau d'interconnexion et une électrode inférieure de l'élément actif du résonateur acoustique.

Avantageusement, l'élément en saillie forme un contact électrique entre le niveau de métallisation du niveau d'interconnexion et une électrode supérieure du résonateur acoustique.

Dans un mode de réalisation de l'invention, l'élément en saillie comprend un plot métallique.

Selon un autre aspect, l'invention a également pour objet un procédé de fabrication d'un circuit intégré comprenant une étape de réalisation d'un élément en saillie disposé au-dessus d'un niveau de métallisation d'un niveau d'interconnexion et une étape de réalisation d'au moins un ensemble bicouche comprenant une couche de matériau à forte impédance acoustique et une couche de matériau à faible impédance acoustique.

L'ordre dans lequel sont réalisés l'élément en saillie et ledit ensemble bicouche dans le procédé est indifférent.

Le procédé permet d'obtenir un résonateur acoustique dont le support comporte des interconnexions intégrées ce qui permet de réduire au minimum le nombre d'étapes supplémentaires consistant à raccorder électriquement un tel résonateur avec le reste du circuit intégré.

Selon une autre caractéristique de l'invention, après la réalisation de l'élément en saillie, une couche de matériau à forte impédance acoustique est formée de façon à recouvrir au moins l'élément en saillie, un matériau permettant de protéger des parties de ladite couche ne recouvrant pas l'élément en saillie, lors de l'élimination d'une partie de ladite couche recouvrant l'élément en saillie, est déposé et une couche de matériau à faible impédance acoustique est formée.

Le procédé permet d'obtenir un support pour résonateur acoustique dont les épaisseurs des couches à forte impédance et à faible impédance acoustique sont bien contrôlées au cours des différentes étapes du procédé. En particulier, le dépôt d'un matériau organique sur les parties de la couche à forte impédance acoustique ne recouvrant pas l'élément en saillie permet avantageusement de les protéger et de les dimensionner avec une épaisseur de l'ordre du quart de la longueur d'onde.

Selon une autre caractéristique de l'invention, l'élément en saillie peut être réalisé en un matériau organique qui est éliminé après la réalisation dudit ensemble bicouche du support et qui est remplacé par un élément en saillie comprenant un métal.

Selon une autre caractéristique de l'invention, l'élément en saillie peut être réalisé après la formation dudit ensemble bicouche.

D'autres caractéristiques et avantages de l'invention apparaîtront à l'examen de la description détaillée des modes de réalisations et de mise en oeuvre nullement limitatifs et des dessins annexés, sur lesquels :
- les figures 1 à 9 illustrent schématiquement les étapes successives d'un mode de réalisation d'un procédé de fabrication d'un résonateur acoustique pourvu d'un élément actif et d'un support,
- les figures 10 et 11 illustrent une vue schématique d'un résonateur acoustique selon un mode de réalisation,
- les figures 12 et 13 illustrent de façon schématique un mode de réalisation particulier d'un résonateur acoustique, et
- les figures 14 à 17 illustrent de façon schématique un autre mode de réalisation particulier d'un résonateur acoustique.

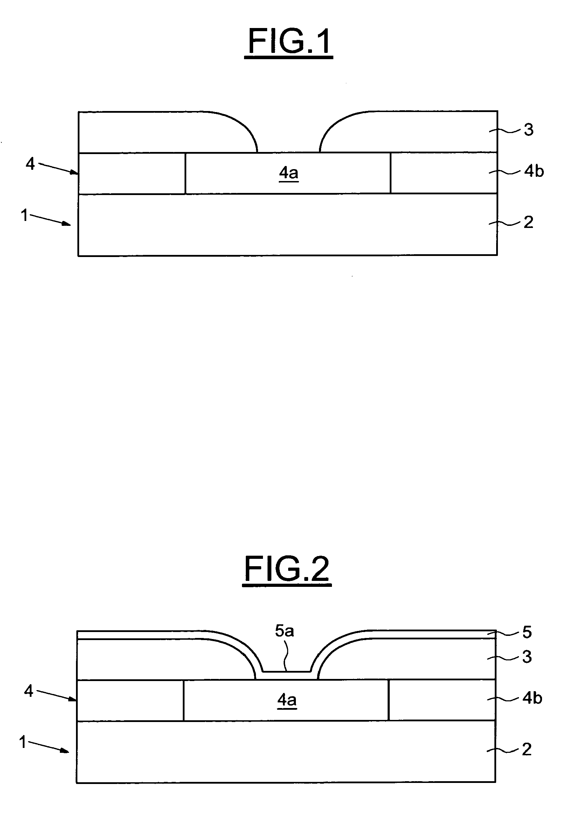

Sur la figure 1, un niveau d'interconnexion 1 d'un circuit intégré comprend une couche diélectrique 2, par exemple de l'oxyde de silicium ou SiOC, et un niveau de métallisation 4 comprenant une ligne conductrice 4a, de préférence en cuivre, réalisée, par exemple, à la suite d'un dépôt électrolytique, et une zone isolante 4b comprenant un matériau diélectrique. Le niveau de métallisation 4 est disposé sur la couche diélectrique 2 et peut présenter une épaisseur de l'ordre de quelques µm. Une couche épaisse photosensible 3 d'un matériau présentant une permittivité électrique faible, de préférence inférieure à 3, comme notamment le benzocyclobutène, a été ensuite déposée sur le niveau de métallisation 4 et a été gravée par voie chimique pour former une fenêtre de manière à découvrir une partie de la surface supérieure de la ligne conductrice 4a. La ligne conductrice 4a comprend ainsi une partie dégagée et une partie recouverte par la couche photosensible 3.

Une couche conductrice 5 est ensuite déposée sur l'ensemble du niveau d'interconnexion 1 de manière à recouvrir à la fois la couche photosensible 3 et la surface supérieure de la ligne conductrice 4a du niveau de métallisation 4 tel qu'illustré sur la figure 2. La couche conductrice 5 comprend une surface supérieure 5a. La couche conductrice 5 peut notamment être du cuivre déposé par pulvérisation cathodique ou par MOCVD (Metal Organic Chemical Vapour Deposition en langue anglaise). La couche 5 peut présenter une épaisseur inférieure à 200 nm.

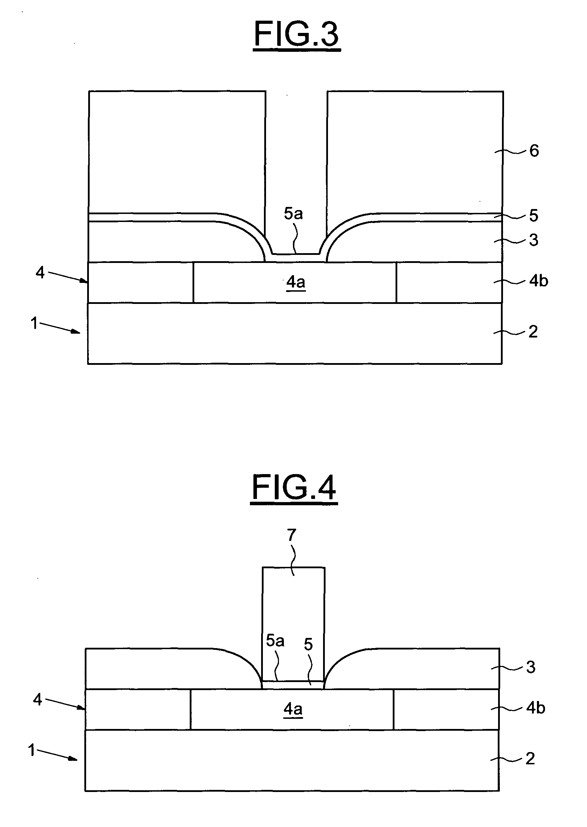

Une couche de résine photosensible 6 est ensuite déposée de façon classique sur l'ensemble du niveau d'interconnexion 1 de manière à recouvrir la couche conductrice 5. La résine 6 subit un recuit, de préférence à une température d'environ 110°C. Une tranchée est ensuite réalisée dans la résine 6 par photolithographie puis par développement jusqu'à la surface supérieure 5a de la couche conductrice 5 tel qu'illustré sur la figure 3.

Un plot métallique 7, de préférence en cuivre, est réalisé par électrodéposition. La couche conductrice 5 présente l'avantage d'apporter le courant au sein de la résine 6 pour réaliser une telle électrodéposition. La résine 6 est retirée par un délaquag e puis une gravure chimique est réalisée pour retirer la couche conductrice 5 recouvrant la couche 3. Le plot métallique 7 est ainsi disposé au-dessus de la surface supérieure de la ligne conductrice 4a du niveau de métallisation 4 tel qu'illustré sur la figure 4. En particulier, le plot 7 est disposé sur la surface supérieure 5a de la couche conductrice 5.

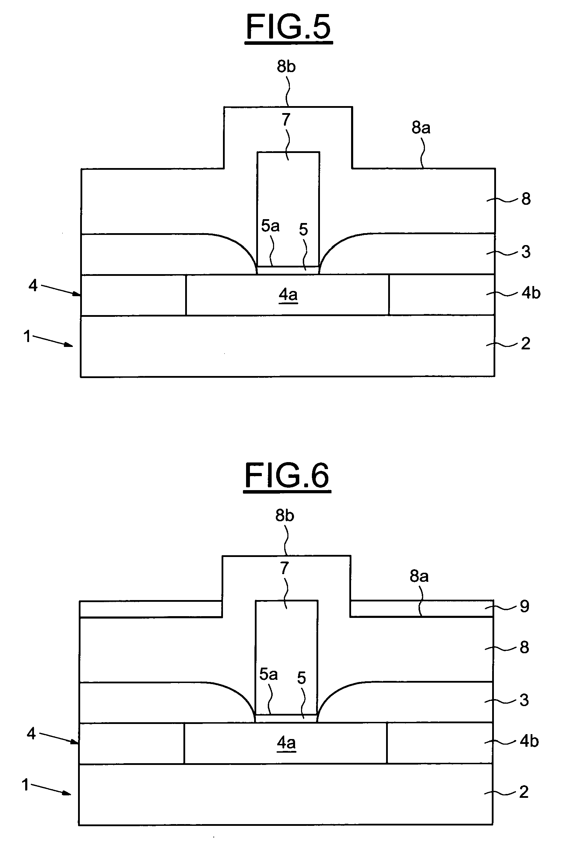

Comme indiqué sur la figure 5, une couche à forte impédance acoustique 8 est déposée de manière à ce qu'une partie 8b recouvre le plot métallique 7 et des parties 8a recouvrent la couche photosensible 3. La couche à forte impédance acoustique 8 peut être réalisée en un matériau diélectrique tel que le nitrure d'aluminium amorphe ou le nitrure de silicium.

Une couche 9 d'un matériau organique, par exemple un polymère, de préférence un polyimide, est déposée sur la couche à forte impédance acoustique 8. La couche 9 est ensuite retirée au niveau de la partie 8b de la couche 8 par une étape de photolithographie recouvrant ainsi les parties 8a tel qu'illustré sur la figure 6. La couche 9 subit ensuite un recuit, de préférence à une température de 350°C, pour favoriser la polymérisation. Il est à noter qu'on peut également éliminer la couche 9 au niveau de la partie 8b de la couche 8 par un polissage mécano chimique après le recuit de la couche 9.

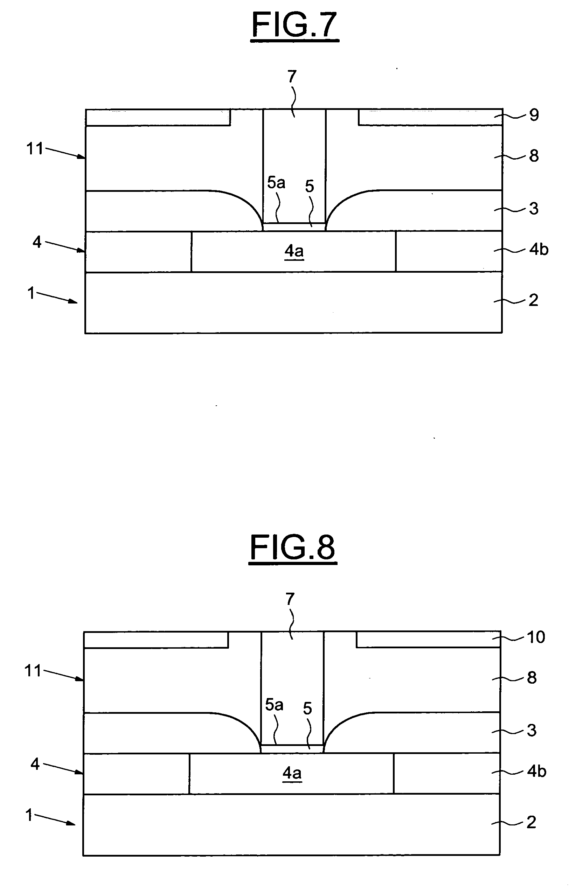

La partie 8b de la couche à forte impédance acoustique 8 est ensuite retirée par un polissage mécano chimique tel qu'illustré sur la figure 7. Ce polissage est réalisé de manière à ne pas entamer la couche 9 ainsi que la surface supérieure du plot métallique 7. La couche 9 permet avantageusement de protéger les parties 8a de la couche à forte impédance acoustique 8 pendant le polissage mécano chimique.

La couche 9 est ensuite retirée par une gravure oxydante sélective afin de ne pas détériorer le plot 7 et la couche 8. Un autre polissage mécano chimique peut être également réalisé afin de réduire les angles au niveau des bords du plot métallique 7 et afin de réduire les éventuelles aspérités de la couche 8 à forte impédance acoustique. Ce polissage mécano chimique est réalisé de manière à ne pas entamer la surface de la couche 8.

Une couche à faible impédance acoustique 10 est déposée sur la couche à forte impédance acoustique 8 pour réaliser le reste du support 11 du résonateur acoustique. Une photolithographie et une gravure sont réalisées pour retirer une partie de la couche à faible impédance acoustique 10 de manière à découvrir la partie supérieure du plot métallique 7 tel qu'illustré sur la figure 8. La couche à faible impédance acoustique 10 peut être réalisée en un matériau à faible permittivité électrique en raison de la correspondance entre la faible permittivité électrique et la faible impédance acoustique. La permittivité du matériau de la couche 10 peut être inférieure à 4. De préférence, la permittivité électrique de la couche 10 peut être inférieure à 3, par exemple un matériau diélectrique de permittivité de l'ordre de 2,9, souvent utilisé comme couche diélectrique dans les zones actives du substrat ou dans un niveau d'interconnexion. On peut par exemple prendre du SiOC ou un matériau à base de SiOC. Il peut être avantageux de réaliser la couche 10 en un matériau à permittivité ultra faible, inférieure à 2,5, par exemple de l'ordre de 2. À cet effet, on peut réaliser la couche 10 en SiOC poreux ou à base d'un tel matériau.

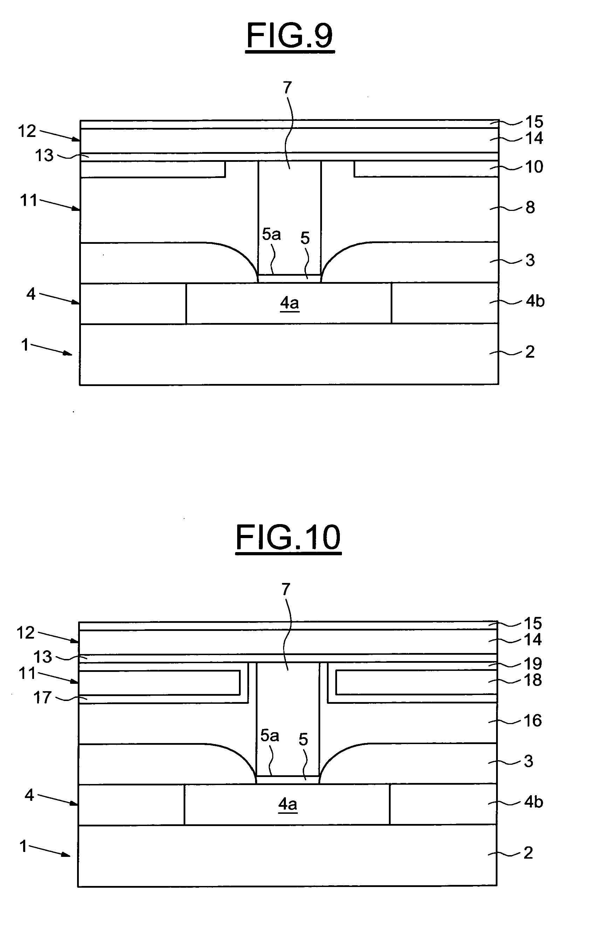

On réalise ensuite l'élément actif 12 du résonateur acoustique de manière classique tel qu'illustré sur la figure 9. L'élément actif 12 comprend trois couches principales sous la forme d'une électrode inférieure 13, d'une couche piézoélectrique 14 et d'une électrode supérieure 15. L'électrode inférieure 13 se retrouve ainsi en contact avec la surface supérieure du plot métallique 7 pour former un contact électrique entre le niveau d'interconnexion 1 et l'élément actif 12. Les électrodes 13 et 15 sont réalisées en un matériau conducteur, par exemple en aluminium, en cuivre, en platine, en molybdène, en nickel, en titane, en nobium, en argent, en or, en tantale, en lanthane, etc. La couche piézoélectrique 14 disposée entre les électrodes 13 et 15 peut être réalisée notamment en nitrure d'aluminium cristallin, en oxyde de zinc, en sulfure de zinc, en céramique de type LiTaO, PbTi O, PbZrTi, KbO₃ ou encore contenant du lanthane, etc. La couche piézoélectrique 14 peut avoir une épaisseur de quelques µm, par exemple 2,4 µm et les électrodes 13 et 15 peuvent avoir une épaisseur nettement inférieure à celle de la couche piézoélectrique 14, par exemple 0,1 µm.

Le support 11 peut comporter également un ensemble bicouche supplémentaire. Comme indiqué sur la figure 10, le support 11 peut ainsi comprendre deux ensembles bicouches comportant chacun une couche à forte impédance acoustique 16 ou 18 et une couche à faible impédance acoustique 17 ou 19.

Le support 11 peut aussi comporter un nombre impair de couches, dans le cas où on forme une première couche à faible impédance acoustique sous un ou plusieurs bicouches.

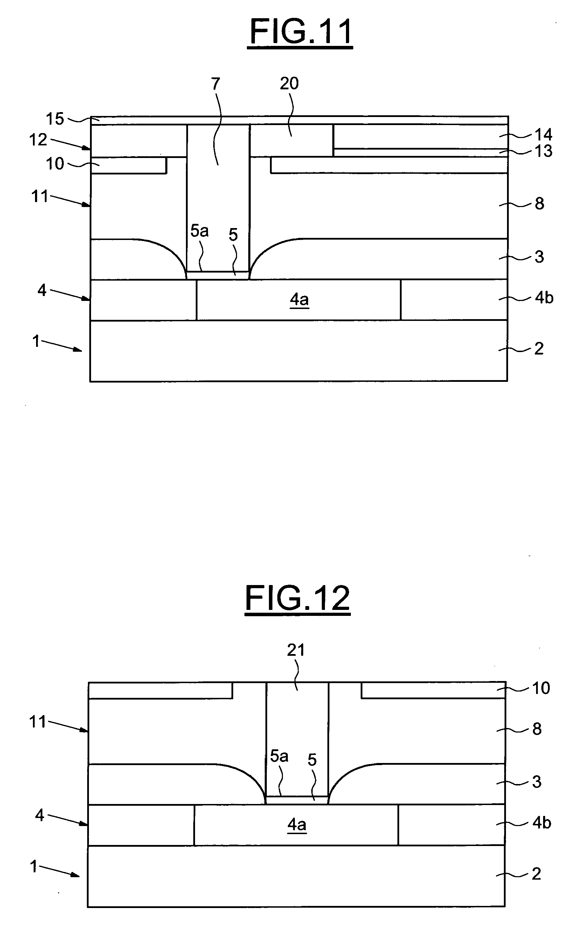

Dans un autre mode de réalisation, le plot métallique 7 forme un contact électrique entre le niveau de métallisation 4 du niveau d'interconnexion 1 et une électrode supérieure 15 tel que représenté sur la figure 11. Dans ce mode de réalisation, la couche à faible impédance acoustique 10 est surmontée en partie par l'électrode inférieure 13 et une couche diélectrique 20. La couche diélectrique 20 se retrouve ainsi comprise entre l'électrode inférieure 13 et l'électrode supérieure 15 et se retrouve en contact avec le plot métallique 7. la couche 20 peut être de l'oxyde de silicium ou une couche organique comme du polyimide.

Dans un autre mode réalisation préféré, le support 11 d'un résonateur acoustique peut comprendre avantageusement un élément en saillie pouvant être un plot comprenant un matériau organique 21 tel que représenté sur la figure 12.

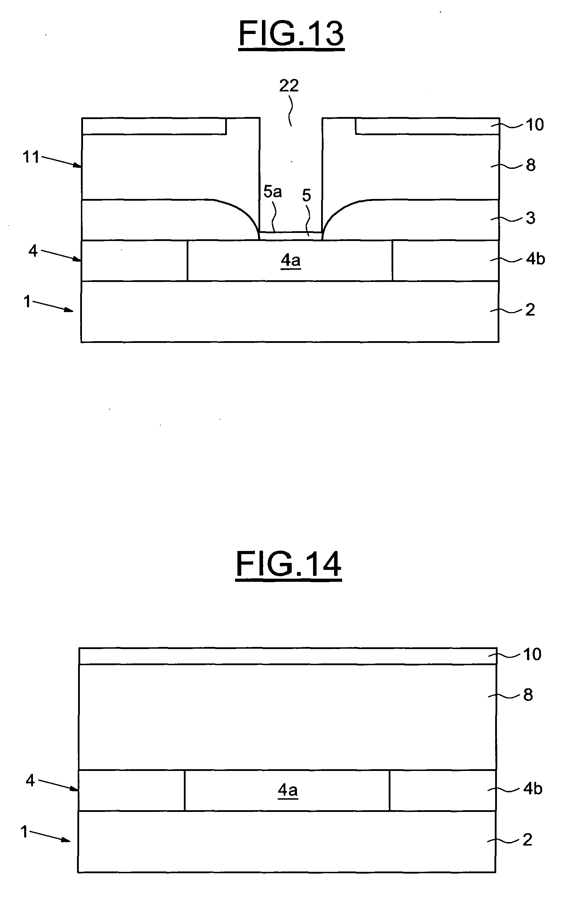

Avant la réalisation de l'élément actif 12 du résonateur acoustique, le plot 21 est éliminé, de préférence par une gravure oxydante, laissant une tranchée 22, tel que représenté sur la figure 13. La gravure sélective du plot 21 permet de ne pas entamer la couche à faible impédance acoustique 10. La tranchée 22 est ensuite remplie par un métal, de préférence du cuivre de manière à former un plot métallique. L'élément actif 12 est ensuite réalisé de la même façon que dans les modes de réalisation précédents.

Selon un autre mode de réalisation, la couche à forte impédance acoustique 8 peut être disposée sur le niveau de métallisation 4 du niveau d'interconnexion 1 et peut être surmontée par la couche à faible acoustique 10, tel que représenté sur la figure 14. En d'autres termes, la couche à forte impédance acoustique 8 peut être prise en sandwich entre le niveau de métallisation 4 et la couche à faible impédance acoustique 10. Comme on le voit sur cette figure, la couche à forte impédance acoustique recouvre l'ensemble de la surface du niveau de métallisation 4.

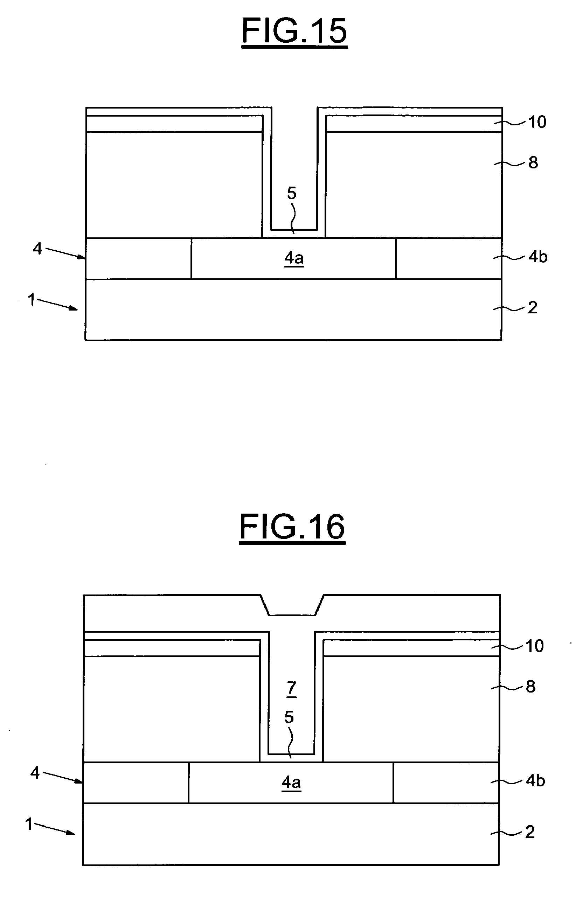

La couche à forte impédance acoustique 8 et la couche à faible impédance acoustique 10 sont ensuite gravées par voie chimique jusqu'à la surface supérieure de la ligne conductrice 4a pour former une tranchée ou un via tel que représenté sur la figure 15. La surface supérieure de la ligne conductrice comprend alors une partie dégagée et une partie recouverte par la couche à forte impédance acoustique 8.

Comme on le voit sur cette figure, une couche conductrice 5 a ensuite été déposée de manière recouvrir la couche à faible impédance acoustique 10 et la ligne conductrice 4a du niveau de métallisation 4. La couche conductrice 5 recouvre alors les parois latérales ainsi que le fond du via. La couche conductrice 5 peut être notamment du cuivre.

Comme le montre la figure 16, une couche 7 en métal, de préférence en cuivre, est ensuite réalisée par électrodéposition de manière à remplir le via et à recouvrir la surface supérieure des couches à faible impédance acoustique 10.

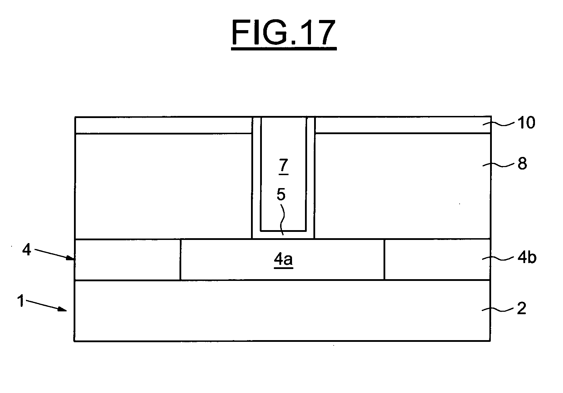

Les parties de la couche 7 recouvrant la couche à faible impédance acoustique 10 sont ensuite retirées par polissage mécano chimique comme le montre la figure 17. Les parties de la couche conductrice 5 recouvrant la surface supérieure des couches à faible impédance acoustique sont retirées par gravure par voie chimique.

On obtient alors un plot métallique 7, de préférence en cuivre, qui permet de réaliser un contact électrique entre le niveau de métallisation 4 du niveau d'interconnexion 1 et l'une des électrodes de l'élément actif 12 du résonateur acoustique.

De cette façon, on peut réaliser en même temps le plot métallique 7 ainsi que d'autres composants du circuit intégré, comme les lignes à faible impédance électrique dans les niveaux de métallisation des interconnexions ou des composants passifs tels que les inductances.

En outre, l'épaisseur de cuivre utilisée pour réaliser le plot métallique 7 est environ égale à 3 ou 4 µm ce qui correspond à l'ordre de grandeur de l'épaisseur de cuivre qui est utilisée pour réaliser des inductances.

De manière conventionnelle, les inductances en cuivre sont réalisées dans un caisson en SiO₂.

A partir du mode de réalisation décrit ci-dessus, on peut donc réaliser les couches diélectriques du résonateur acoustique ainsi que le plot métallique 7 en même temps que les inductances et le caisson diélectrique dans lequel de telles inductances sont réalisées.

Comme on l'a vu précédemment, l'élément en saillie 7 peut prendre, de préférence, la forme d'un plot métallique, m ais il peut également prendre d'autres types de formes fermées.

## Revendications

1. Circuit intégré comprenant au moins un niveau d'interconnexion (1) et un résonateur acoustique muni d'un élément actif (12) et d'un support (11) comprenant au moins un ensemble bicouche comprenant une couche de matériau à forte impédance acoustique (8) et une couche de matériau à faible impédance acoustique (10) **caractérisé par le fait que** ledit support (11) comprend en outre un élément en saillie (7) disposé au-dessus d'un niveau de métallisation (4) du niveau d'interconnexion (1) permettant de réaliser un contact électrique entre le niveau d'interconnexion (1) et l'élément actif (12) du résonateur acoustique.

2. Circuit intégré selon la revendication 1, **caractérisé par le fait que** l'élément en saillie (7) forme un contact électrique entre le niveau de métallisation (4) du niveau d'interconnexion (1) et une électrode inférieure (13) de l'élément actif (12) du résonateur acoustique.

3. Circuit intégré selon l'une des revendications 1 à 2, **caractérisé par le fait que** l'élément en saillie (7) forme un contact électrique entre le niveau de métallisation (4) du niveau d'interconnexion (1) et une électrode supérieure (15) du résonateur acoustique.

4. Circuit intégré selon l'une quelconque des revendications 1 à 3, **caractérisé par le fait que** l'élément en saillie (7) comprend un plot métallique.

5. Procédé de fabrication d'un circuit intégré comprenant une étape comprenant la réalisation d'un élément en saillie (7) disposé au-dessus d'un niveau de métallisation (4) d'un niveau d'interconnexion (1) et une étape comprenant la réalisation d'au moins un ensemble bicouche comprenant une couche de matériau à forte impédance acoustique (8) et une couche de matériau à faible impédance acoustique (10).

6. Procédé selon la revendication 5, **caractérisé par le fait qu'**après la réalisation de l'élément en saillie (7), une couche de matériau à forte impédance acoustique (8) est formée de façon à recouvrir au moins l'élément en saillie (7), et **par le fait qu'**un matériau (9) permettant de protéger des parties (8a) de ladite couche (8) ne recouvrant pas l'élément en saillie (7), lors de l'élimination d'une partie (8b) de ladite couche (8) recouvrant l'élément en saillie (7), est déposé, et **par le fait qu'**une couche de matériau à faible impédance acoustique (10) est formée.

7. Procédé selon la revendication 5, **caractérisé par le fait que** l'élément en saillie (7) est réalisé en un matériau organique (21) éliminé après la réalisation dudit ensemble bicouche du support (11) et qui est remplacé par un élément en saillie comprenant du métal.

8. Procédé selon la revendication 5, **caractérisé par le fait que** l'élément en saillie (7) est réalisé après la formation dudit ensemble bicouche du support (11).
